# FASCICULE DE BREVET EUROPEEN

(11) **EP 3 246 819 B1**
(45) Date de publication et mention de la délivrance du brevet: **28.08.2019**
(21) Numéro de dépôt: 16198174.1
(22) Date de dépôt: 10.11.2016
(51) Int. Cl.: G06F 12/02, G06F 11/10, G11C 29/52

(54) **COMPTEUR EN MÉMOIRE FLASH**
ZÄHLER IN EINEM FLASH-SPEICHER
FLASH MEMORY COUNTER

(30) Priorité: 20.05.2016 FR 1654499
(43) Date de publication de la demande: 22.11.2017
(73) Titulaire: PROTON WORLD INTERNATIONAL N.V., 1831 Diegem (BE)
(72) Inventeur: DAWIRS, Michel, 1970 Wezembeek-Oppem (BE); DOCQUIER, Guillaume, 4000 Liège (BE)
(74) Mandataire: Cabinet Beaumont

(56) Documents cités:
- EP-A1- 2 058 737
- EP-A1- 2 940 690
- WO-A1-2012/013683
- US-A1- 2005 081 101

## Description

### Domaine

La présente description concerne de façon générale les circuits électroniques et, plus particulièrement, les circuits exploitant une mémoire flash. La présente description vise plus particulièrement la gestion de compteurs en mémoire flash.

### Exposé de l'art antérieur

Les mémoires flash sont de plus en plus utilisées dans des microcontrôleurs pour stocker de façon non volatile des informations.

Le stockage de données dans une mémoire flash présente diverses contraintes temporelles liées à la granularité des opérations réalisées, l'écriture s'effectuant par mot (par exemple, par mot de quatre octets) tandis que l'effacement s'effectuant par page de plusieurs mots (quelques dizaines à quelques centaines de mots).

La gestion d'un compteur en mémoire flash requiert que les transactions (incrément/décrément) réalisées et stockées respectent un critère d'atomicité. L'atomicité d'une transaction correspond à s'assurer que des données stockées en mémoire présentent bien un état exploitable et intègre. Cela revient à s'assurer que des données en mémoire non volatile présentent soit l'état avant la transaction soit l'état après la transaction concernée mais qu'elles ne présentent pas un état intermédiaire.

La gestion de l'atomicité des transactions est particulièrement utilisée dans des applications où une interruption de l'alimentation du circuit ou l'apparition d'une perturbation accidentelle ou volontaire peut engendrer le stockage de données dans un état les rendant soit inexploitables par la suite soit vulnérables du point de vue de la confidentialité ou de leur intégrité. Par exemple, dans le domaine des cartes à microcircuit, on souhaite s'assurer qu'en cas d'arrachement (tearing) volontaire ou accidentel d'une carte du lecteur dans laquelle elle se trouve, les informations contenues dans une mémoire flash de la carte soient fiables. Dans un circuit intégrant un module de sécurité, l'équivalent de l'arrachement correspond à une coupure de l'alimentation du circuit.

Le document EP 2 940 690 décrit un procédé de stockage d'un compteur dans au moins deux pages de mémoire non volatile.

Le document WO2012/013683 décrit des appareils électroniques comprenant une mémoire non volatile.

### Résumé

La_présente_invention_est_définie_dans_les_revendications_ jointes.

Il existe un besoin d'améliorer la gestion de compteurs stockés en mémoire flash, en particulier pour préserver le caractère atomique des incréments/décréments de la valeur du compteur.

Il existe également un besoin d'améliorer la gestion de plusieurs compteurs dans une même mémoire flash.

Un mode de réalisation pallie tout ou partie des inconvénients des techniques connues de gestion de compteurs dans une mémoire flash.

Un mode de réalisation améliore l'endurance (le nombre d'écritures possible) du stockage d'un compteur dans une mémoire flash.

Un mode de réalisation facilite la gestion de l'atomicité des mises à jour d'un compteur dans une mémoire flash.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique et sous forme de blocs, un mode de réalisation d'un circuit électronique du type auquel d'appliquent, à titre d'exemple, les modes de réalisation qui vont être décrits ;
la figure 2 illustre un mode de réalisation d'une structure d'enregistrement d'un compteur ;
la figure 3 illustre un mode de réalisation d'une organisation de données dans une page de mémoire flash ;
la figure 4 illustre un mode de réalisation d'une structure d'une trame d'enregistrement d'une mise à jour d'un compteur ;
la figure 5 est un schéma-blocs illustrant un mode de réalisation d'un incrément d'un compteur dans la mémoire ;
la figure 6 est un schéma-blocs illustrant un mode de réalisation d'une préparation d'une page suivante pour écriture quand une page courante est pleine ;
la figure 7 illustre, sous forme de schéma-blocs, un mode de réalisation d'une lecture de la valeur d'un compteur dans la mémoire flash ; et
la figure 8 est un schéma-blocs illustrant un mode de réalisation d'une récupération d'atomicité.

### Description détaillée

De mêmes éléments ont été désignés par de mêmes références aux différentes figures.

Par souci de clarté, seuls les étapes et éléments utiles à la compréhension des modes de réalisation qui vont être décrits ont été représentés et seront détaillés. En particulier, le fonctionnement électrique d'une mémoire flash lors des étapes d'écriture, de lecture et d'effacement n'ont pas été détaillées, les modes de réalisation décrits étant compatibles avec les technologies usuelles des mémoires flash. De plus, les applications utilisant des compteurs et une gestion d'atomicité n'ont pas non plus été détaillées, les modes de réalisation décrits étant, là encore, compatibles avec les applications usuelles.

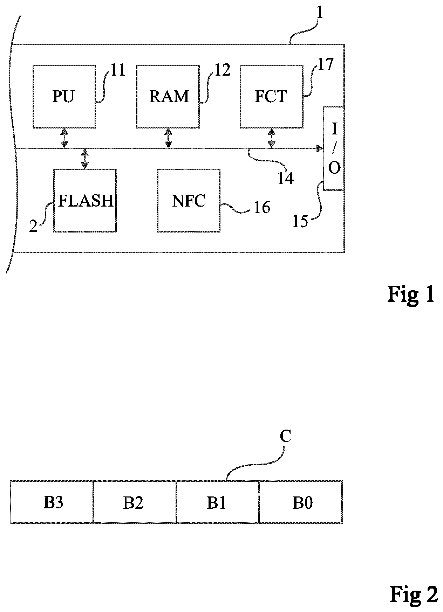

La figure 1 représente, de façon très schématique et sous forme de blocs, un mode de réalisation d'un circuit électronique 1 du type auquel d'appliquent, à titre d'exemple, les modes de réalisation qui vont être décrits.

Le circuit 1 comporte :
une unité de traitement 11 (PU), par exemple une machine d'états, un microprocesseur, un circuit logique programmable, etc. ;
une ou plusieurs zones 12 (RAM) de stockage volatil, par exemple de type mémoire RAM ou registres, pour stocker temporairement des informations (instructions, adresses, données) pendant les traitements ;
une ou plusieurs zones de stockage non volatil, dont au moins une mémoire 2 de type flash (FLASH) pour stocker des informations de façon durable et en particulier quand le circuit n'est pas alimenté ;
un ou plusieurs bus 14 de données, d'adresses et/ou de commandes entre les différents éléments internes au circuit 1 ; et
une interface d'entrée-sortie 15 (I/O) de communication, par exemple de type bus série, avec l'extérieur du circuit 1.

Le cas échéant, le circuit 1 intègre également un circuit 16 de communication sans contact (CLF - ContactLess Front-end), de type communication en champ proche (Near Field Communication - NFC).

Par ailleurs, le circuit 1 peut intégrer d'autres fonctions, symbolisées par un bloc 17 (FCT), selon l'application, par exemple, un crypto-processeur, d'autres interfaces, d'autres mémoires, etc.

La gestion d'un ou plusieurs compteurs stockés dans une mémoire flash et la gestion de l'atomicité des incréments / décréments de ces compteurs dans un circuit équipé d'une mémoire flash est particulière car la mémoire flash ne présente pas la même granularité de traitement selon le type d'opération. En particulier, l'écriture s'effectue par mot (d'un octet ou de quelques octets) tandis que l'effacement s'effectue par page. La taille d'un mot correspond généralement à la taille d'un registre recevant les données en série pour les transférer en parallèle au plan mémoire pour écriture. Une page est définie comme la taille minimale susceptible d'être adressée simultanément pour effacement. Typiquement, une page représente, dans une mémoire flash, 64, 128, 256, 512 ou 1024 octets.

Une mémoire flash se programme, à partir d'un état initial, désigné arbitrairement 1, vers des états 0 (états non conducteurs des cellules). Cela signifie que les cellules de la mémoire doivent être initialisées à un état haut (effacement) et que, pour stocker une donnée (écriture), on intervient (programmation à 0) ou pas (état du bit à 1) sur les états des bits par mot de données.

Afin de garantir l'atomicité des transactions, le stockage en mémoire flash d'une donnée ne doit être considéré comme valide qu'une fois que la transaction est terminée et que les données sont dites stables. En pratique, les procédés de gestion d'atomicité activent un indicateur de traitement d'une donnée lorsque celle-ci est extraite de la mémoire non volatile, puis organisent le stockage de la donnée mise à jour, une fois le traitement terminé, l'indicateur de traitement changeant alors d'état. L'atomicité peut concerner une quantité plus ou moins importante de données selon la nature de la transaction.

Le caractère atomique des transactions est particulièrement important dans le cas de compteurs pour lesquels il est nécessaire de s'assurer que l'information stockée dans la mémoire flash, par exemple le solde d'un portemonnaie électronique ou d'une autorisation d'achat, ou le nombre de tentatives de saisie d'un code, est stocké de façon fiable.

Généralement, pour garantir l'atomicité d'une transaction, on utilise des espaces de stockage temporaire (Buffer) d'atomicité qui sont mis à jour avec les informations initiales, puis finales, pour transfert dans la mémoire non volatile principale.

Toutefois, dans le cas d'une mémoire flash, une difficulté réside dans la procédure d'effacement en raison de sa granularité par page qui est relativement longue par rapport à l'opération d'écriture par mot.

Dans les applications sans contact, les transactions doivent être effectuées très rapidement en raison du caractère fugace de la communication qui est lié à la durée pendant laquelle le circuit 1 peut communiquer avec un terminal. Or, la gestion de l'atomicité des transactions en utilisant des tampons en mémoire flash prend du temps, en raison des opérations d'effacement qui sont nécessaires pour autoriser une programmation.

Selon les modes de réalisation qui vont être décrits, on prévoit d'organiser de façon particulière le stockage de compteurs dans des pages d'une mémoire flash.

La figure 2 illustre un mode de réalisation d'une structure d'enregistrement d'un compteur.

Selon ce mode de réalisation, un compteur C, ou plutôt une valeur de ce compteur, est stocké dans quatre octets B0, B1, B2 et B3. Quatre octets est une taille largement suffisante pour représenter la valeur d'un compteur quel qu'il soit. Toutefois, d'autres tailles, par exemple un octet, deux octets, etc. peuvent être prévues. Ici, on tire profit avec quatre octets que cela correspond à la taille d'un mot de la mémoire flash.

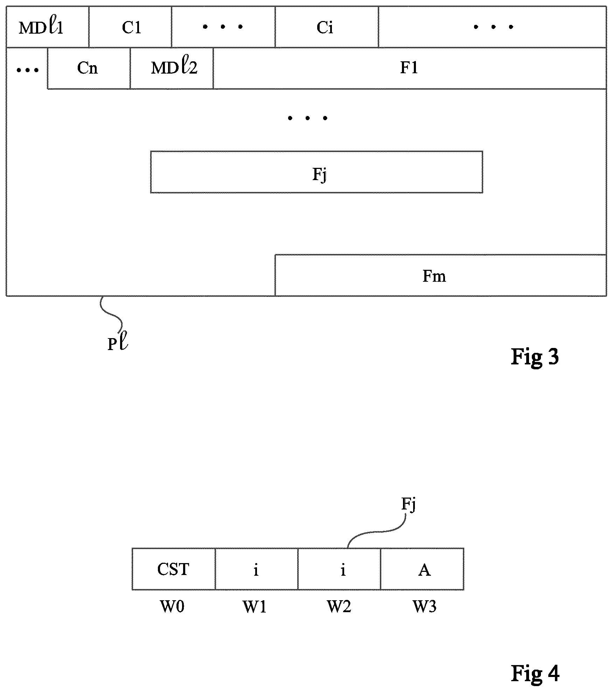

La figure 3 illustre un mode de réalisation d'une organisation de données dans une page de mémoire flash.

Afin de respecter la contrainte d'effacement, la mémoire est physiquement organisée en pages Pl, représentant la granularité d'effacement et comporte au moins deux pages. Chaque page comporte un même nombre de mots, constituant la granularité d'écriture (et de lecture). Toutes les pages dans lesquelles sont stockés le ou les compteurs présentent la même structure. Un circuit de gestion de la mémoire est chargé d'organiser son adressage, l'écriture, la lecture et l'effacement. Ce circuit ou unité de gestion est le cas échéant l'unité de traitement. L'unité de gestion de la mémoire 2 convertit des adresses virtuelles fournies par les différentes entités en des adresses physiques.

Chaque page Pl commence par des données d'entête. Physiquement, les données d'entête peuvent être n'importe où dans la page mais du point de vue logique, on considère que la page commence préférentiellement par des données d'entête. Ces données d'entête comportent :
un premier mot de métadonnées MDl1 contenant le numéro de la page, incrémenté à chaque utilisation d'une nouvelle page lorsque la page précédente est pleine ;
n mots Ci contenant chacun la valeur initiale d'un ou plusieurs compteurs pour la page concernée (selon la taille des compteurs, quelques compteurs peuvent se partager un même mot Ci-on prendra par la suite l'exemple d'un compteur par mot) ; et
un deuxième mot de métadonnées MDl2 contenant un code de contrôle d'erreur de type CRC, signature ou autre, calculé à partir des valeurs initiales des compteurs Ci et, de préférence, du numéro de page.

Le reste de la page Pl est destiné à contenir des enregistrements représentant des incréments des compteurs (on fera par la suite référence à des incréments mais il peut également s'agir de décréments). Selon ce mode de réalisation, le reste de la page est divisé en m trames Fj comportant chacune un même nombre de mots de données (par exemple, quatre mots). On peut donc stocker, dans chaque page jusqu'à m trames Fj représentant des enregistrements de mises à jour successives (mots d'incréments) d'un ou plusieurs compteurs.

On rappelle que, lorsqu'un mot est vierge (effacé), tous ses bits sont dans un premier état (désigné haut ou 1). La programmation d'un mot pour y stocker une valeur consiste à sélectionner les bits des octets du mot qui doivent changer d'état et être écrits (basculer vers l'état bas ou 0). La programmation d'un drapeau ou indicateur consiste à programmer le bit ou les bits de l'octet à l'état correspondant à l'état bas. On rappelle également qu'une fois écrit ou programmé à l'état 0, le contenu du mot ne peut pas être modifié sauf à effacer la page entière et à la reprogrammer. Ainsi, une fois qu'un mot est écrit dans une page, on ne peut plus y toucher sauf à effacer toute la page. L'écriture dans les pages Pl s'effectue séquentiellement dans chaque page.

L'écriture des données dans la mémoire s'effectue trame par trame et mot par mot au fur et à mesure qu'ils sont reçus et successivement dans la page. Ainsi, en cas d'écritures successives d'un incrément d'un même compteur, cet incrément peut se retrouver écrit plusieurs fois dans la page (dans différentes trames) au fur et à mesure des écritures. Cela participe à la résolution du problème d'atomicité dans la mesure où, à partir du moment où la page contient la valeur initiale Ci d'un compteur, on pourra toujours, lors des lectures ultérieures, revenir au dernier incrément enregistré de façon stable.

La figure 4 illustre un mode de réalisation d'une structure d'une trame Fj d'enregistrement d'une mise à jour d'un compteur.

Selon ce mode de réalisation, on écrit en premier un mot W0 de valeur fixe CST, puis au moins un mot W1 contenant un identifiant i du compteur concerné par la trame Fj et enfin un mot W3 par exemple non programmé ou contenant une valeur A, par exemple un code de contrôle d'erreur CRC de la trame. De préférence, on stocke deux fois (dans les mots W1 et W2), l'identifiant i du compteur. La valeur fixe CST est, par exemple, la même pour toutes les trames Fj de la page Pl. En variante, il s'agit d'une constante identique pour toutes les pages de la mémoire ou, à l'inverse, d'une valeur déterministe différente pour chaque trame, basée sur la position (l'identifiant) de la trame. La valeur CST ne doit cependant pas dépendre du compteur incrémenté dans la trame. Grace à l'utilisation d'une valeur fixe pour le mot W0 de chaque trame Fj, on sera en mesure de s'assurer qu'il n'y a pas eu d'arrachement ou d'attaque au début de l'écriture de la trame, par exemple une tentative de modification du contenu d'un mot lors d'une attaque. La valeur A est un indicateur d'annulation. Elle n'est normalement pas programmée. Elle sert à indiquer qu'une trame doit être ignorée suite à une détection d'arrachement.

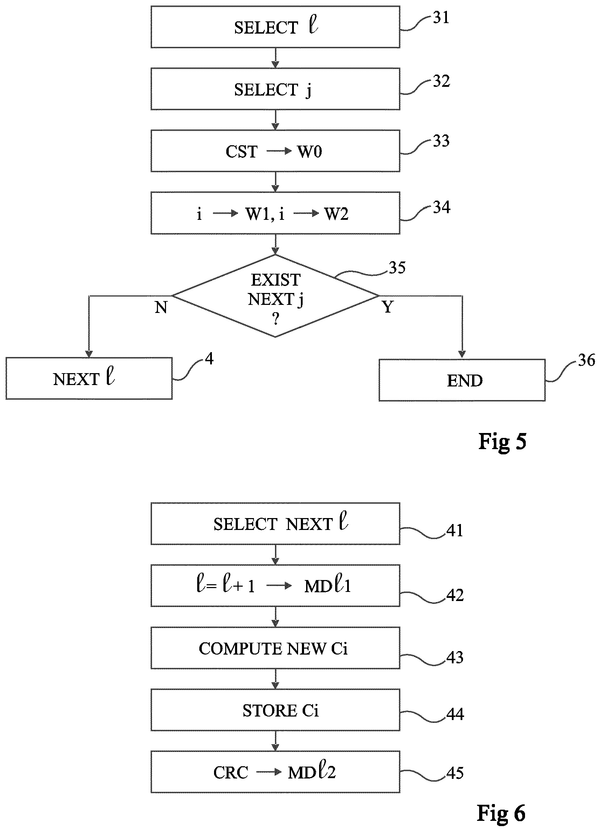

La figure 5 est un schéma-blocs illustrant un mode de réalisation d'un incrément d'un compteur dans la mémoire.

On suppose que la page courante Pl a été précédemment initialisée avec les données d'entête.

On commence par sélectionner (bloc 31, SELECT l) la page Pl ayant le numéro de page l le plus élevé en parcourant (en lisant) les mots de métadonnées MDl1 (ou MDl2) des pages.

Puis, on identifie (bloc 32, SELECT j), la première trame Fj disponible séquentiellement dans la page Pl. Cette sélection s'effectue, par exemple, en parcourant les trames successivement jusqu'à la première dont le mot W0 destiné à la valeur fixe CST n'est pas programmé. En variante, on sélectionne la première trame dont l'identifiant de compteur i n'est pas programmé. On suppose dans cet exemple qu'une nouvelle page est ouverte à la fin de l'écriture de la dernière trame d'une page. Par conséquent on trouve forcément une trame disponible à l'étape 32.

En variante, si aucune trame n'est libre, cela signifie que la page est pleine. On exécute alors une sous-routine d'ouverture d'une nouvelle page. Cette sous-routine sera exposée plus loin en relation avec la figure 6.

Une fois que la trame Fj est sélectionnée, on commence par écrire (bloc 33, CST -> W0), dans la trame Fj, le premier mot W0 de valeur CST fixe. On écrit ensuite (bloc 34, i -> W1, i - W2) l'identifiant du compteur à incrémenter dans les mots W1 et W2. Le mot W3 est laissé non programmé.

On vérifie alors si la page est pleine, c'est-à-dire s'il existe une trame Fj disponible pour la prochaine écriture (bloc 35, EXIST NEXT j ?). Dans l'affirmative (sortie Y du bloc 35), l'écriture est terminée (bloc 36, END).

Dans la négative (sortie N du bloc 35), c'est-à-dire s'il n'y a plus de trame disponible, on prépare la page suivante pour la prochaine écriture (bloc 4, NEXT l).

La figure 6 est un schéma-blocs illustrant un mode de réalisation d'une préparation d'une page suivante pour écriture quand une page courante est pleine.

On commence (bloc 41, SELECT NEXT l) par sélectionner la prochaine page Pl disponible, c'est-à-dire vierge ou effacée. La valeur du nombre de pages écrites, incrémentée de 1, (bloc 42, l=l+1 → MDl1) est stockée dans le premier mot de métadonnée MDl1. Puis, on calcule les valeurs finales des compteurs de la page précédente qui deviennent les valeurs initiales pour la nouvelle page (bloc 43, COMPUTE NEW Ci) et on stocke ces valeurs (bloc 44, STORE Ci) dans la nouvelle page. Enfin, on calcule et on stocke (bloc 45, CRC → MDl2), dans le deuxième mot de métadonnées, le CRC des valeurs initiales des compteurs désormais enregistrées.

Une fois ces opérations réalisées, la page précédente est obsolète et peut donc être effacée. Ainsi, le nombre minimal de pages mémoire pour la mise en oeuvre des modes de réalisation décrits est deux. Toutefois, on pourra prévoir un plus grand nombre de pages mémoire afin d'augmenter la longévité des compteurs, le nombre d'effacements d'une même page étant limité par l'endurance de la mémoire.

Le calcul des valeurs finales des compteurs s'effectue de la même manière que la lecture d'un compteur en effectuant le calcul correspondant pour chaque compteur et sur l'ensemble de la page.

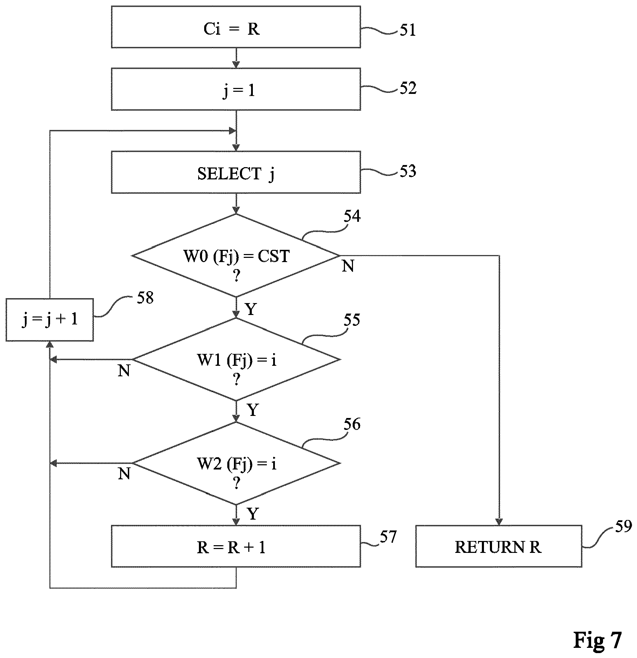

La figure 7 illustre, sous forme de schéma-blocs, un mode de réalisation d'une lecture d'une donnée A dans la mémoire 2.

On commence (bloc 51, Ci -> R), par lire la valeur initiale du compteur dans la page et on la stocke dans un registre ou un élément de mémoire volatile. On parcourt ensuite les trames successives Fj de la page en recherchant celles qui concernent le compteur Ci.

Par exemple, on initialise un index j à 1 (bloc 52, j=l). Puis, on sélectionne la trame de rang j (bloc 53, Select j) et on vérifie qu'elle soit programmée. Par exemple, on vérifie que son premier mot contienne la constante CST (bloc 54, W0(Fj)=CST ?). Dans l'affirmative (sortie Y du bloc 54), on lit son mot W1 (ou W2) pour vérifier qu'il contient l'identifiant i (bloc 55, W1(Fj)= i ?). Dans l'affirmative (sortie Y du bloc 55), on effectue le même test (bloc 56, W2(Fj)= i ?) sur l'autre mot d'identifiant W2 (ou W1). Cette double vérification optionnelle apporte une sécurité supplémentaire. Si le ou les deux tests 55 et 56 sont positifs (sortie Y du bloc 56), on incrémente la valeur du registre R (bloc 57, R=R+1). On incrémente alors l'index de trame (bloc 58, j=j+1) et on sélectionne la trame suivante (bloc 53). Si l'un des tests 55 ou 56 s'avère négatif (sortie N du bloc 55 ou 56), on passe également à la trame suivante (blocs 58 et 53).

Quand toutes les trames écrites ont été parcourues (sortie N du bloc 54), on retourne la valeur du registre R (bloc 59, RETURN R) comme étant la valeur finale du compteur Ci.

Lors d'un changement de page, on peut économiser le test 54 dans la mesure où toutes les trames sont écrites.

Avec un tel processus d'écriture et de lecture dans la mémoire 2, on est en mesure, en lecture, de retrouver la dernière transaction atomique pour chaque compteur. En effet, si une transaction ne s'est pas terminée correctement l'identifiant i n'est pas programmé dans le mot W2 et la valeur du registre n'est pas incrémentée. Si le mot W3 est utilisé en indicateur d'écriture, il suffit de commencer par lire ce mot à chaque trame. Ce mot W3 peut d'ailleurs comporter un code de type CRC calculé sur les valeurs des trois premiers mots afin d'effectuer une vérification supplémentaire lors de la lecture et détecter une éventuelle perturbation de la trame.

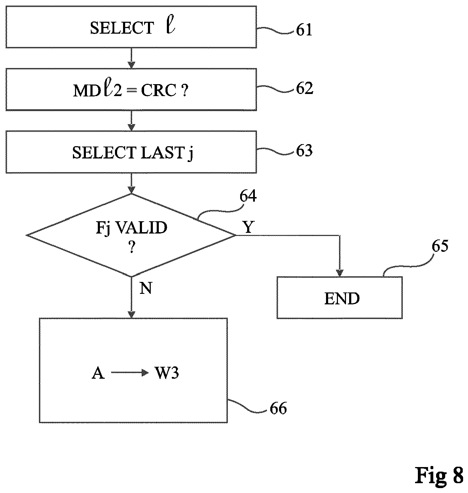

La figure 8 est un schéma-blocs illustrant un mode de réalisation d'une récupération d'atomicité.

En pratique, ce processus est effectué au démarrage ou lors d'une réinitialisation du circuit, ce qui revient à vérifier l'atomicité après chaque arrachement ou extinction accidentelle ou volontaire.

On commence par sélectionner (bloc 61, SELECT l) la page ayant le numéro d'ordre l maximal.

Puis, on charge ses valeurs initiales Ci et on vérifie le code CRC contenu dans la métadonnée d'entête (bloc 62, MDl2=CRC ?) afin de s'assurer que l'arrachement ne s'est pas produit pendant l'initialisation de la page et que les valeurs initiales des compteurs sont valides.

Puis, on sélectionne (bloc 63, SELECT LAST j) la dernière trame écrite dans cette page et on vérifie qu'elle contient bien des informations correctes (bloc 64, Fj VALID ?). Par exemple, on vérifie que le premier mot W0 contient bien la constante CST et que les deux mots W1 et W2 sont bien programmés avec un identifiant i de compteur existant. En variante, si le dernier mot W3 contient un CRC, on vérifie ce CRC.

Si tout est correct (sortie Y du bloc 64), il n'y pas de problème d'atomicité et la coupure ou réinitialisation s'est effectuée alors que les processus d'écriture dans la mémoire flash étaient terminés. Le fonctionnement normal reprend alors son cours (bloc 65, END). Dans le cas contraire (bloc 66, A -> W3), la valeur A est programmée dans le mot W3 pour indiquer que la trame courante contient une mauvaise valeur et doit être ignorée. En variante, les valeurs des compteurs sont transférées dans une nouvelle page. Pour cela, on met en oeuvre un processus similaire à celui d'initialisation d'une nouvelle page quand la page courante est pleine (figure 6).

Avec un tel processus d'écriture dans la mémoire 2, on est en mesure, en lecture, de retrouver la dernière transaction atomique pour chaque compteur.

Selon une variante de réalisation, un des mots des trames Fj (soit un mot supplémentaire, soit le mot W2 ou W3) contient la valeur d'incrément/décrément à apporter au compteur. Ainsi, l'incrément n'est pas nécessairement d'une unité. De plus, un même compteur peut être mis à jour dans les deux sens (incrément/décrément) dans une même page et ce avec des valeurs différentes à chaque incrément/décrément.

Le cas échéant, l'incrément/décrément est implicite, chaque trame écrite représente un incrément ou un décrément sans qu'il soit nécessaire d'indiquer dans la trame la valeur de cet incrément/décrément. Cela peut concerner en particulier le cas d'un incrément ou décrément unitaire.

Le nombre de compteurs stockés (au moins un) dépend de l'application et n'affecte pas le fonctionnement.

Un avantage des modes de réalisation qui ont été décrits est qu'ils améliorent la gestion de compteurs dans une mémoire flash en préservant un critère d'atomicité.

Un autre avantage est qu'ils permettent aisément de remonter à la dernière valeur atomique d'un compteur.

Divers modes de réalisation ont été décrits. Diverses variantes et modifications apparaîtront à l'homme de l'art. Par ailleurs, la mise en oeuvre pratique des modes de réalisation qui ont été décrits est à la portée de l'homme du métier à partir des indications fonctionnelles données ci-dessus et en utilisant des circuits en eux-mêmes usuels. Notamment, l'organisation de l'adressage de la mémoire et la génération des signaux adaptés à sa commande et à cet adressage fait appel à des techniques en elles-mêmes usuelles.

## Revendications

1. Procédé de stockage d'au moins un compteur (Ci) dans une mémoire flash (2), dans lequel chaque page (Pl) de la mémoire affectée au stockage du ou des compteurs comporte :
des données d'entête incluant un premier mot (MDl1) destiné à contenir un numéro (l) de la page, un mot (Ci) par compteur pour stocker une première valeur de celui-ci, et un deuxième mot (MDl2) destiné à contenir un code de contrôle d'erreur calculé en tenant compte des premières valeurs ;
des trames (Fj) ayant toutes un même nombre de mots, chaque trame étant destinée à contenir une valeur (CST) indépendante des données de la trame, et au moins une occurrence d'un identifiant (i) d'un compteur, chaque trame écrite représentant un incrément ou décrément de la valeur du compteur concerné par rapport à sa première valeur ;
dans lequel,
lesdites données d'entête sont écrites avant l'écriture d'une première trame (Fj) dans la page (Pl) ;
la valeur courante d'un compteur est calculée en mettant à jour la première valeur de ce compteur en fonction de toutes les trames (Fj) de la page qui comportent l'identifiant (i) de ce compteur ; et
l'initialisation d'une nouvelle page s'accompagne d'une écriture de ces données d'entête avec, comme première valeur, les valeurs courantes des compteurs calculées sur la base de la page précédente.

2. Procédé selon la revendication 1, dans lequel une nouvelle trame (Fj) est écrite à chaque mise à jour de la valeur d'un compteur.

3. Procédé selon la revendication 1 ou 2, dans lequel les trames (Fj) sont écrites séquentiellement dans une page (Pl).

4. Procédé selon l'une quelconque des revendications 1 à 3, dans lequel chaque trame (Fj) est en outre destinée à contenir un mot de code de contrôle d'erreur calculé en tenant compte des autres mots de la trame.

5. Procédé selon l'une quelconque des revendications 1 à 4, dans lequel ladite valeur (CST) indépendante des données de la trame est la même pour toutes les trames de la page.

6. Procédé selon l'une quelconque des revendications 1 à 5, dans lequel chaque trame (Fj) comporte en outre un mot de stockage de la valeur d'incrément ou de décrément du compteur concerné.

7. Procédé selon l'une quelconque des revendications 1 à 6, dans lequel la valeur d'incrément ou de décrément est l'unité.

8. Circuit électronique (1) comportant :
une mémoire flash (2) ; et
un circuit de gestion (11) configuré pour mettre en oeuvre le procédé selon l'une quelconque des revendications 1 à 7.

## Patentansprüche

1. Ein Verfahren zum Speichern mindestens eines Zählers (Ci) in einem Flash-Speicher (2), wobei jede Seite (Pl) des Speichers, die dem Speicher des/der Zähler zugeordnet ist, Folgendes aufweist:
Headerdaten, die ein erstes Wort (MDl1) enthalten, das dazu bestimmt ist, eine Zahl (I) der Seite zu enthalten, wobei die Headerdaten weiter ein Wort (Ci) pro Zähler enthalten, um einen ersten Wert davon zu speichern, und weiter ein zweites Wort (MDl2) enthalten, das dazu bestimmt ist, einen Fehlerkontrollcode zu enthalten, der unter Berücksichtigung erster Werte berechnet wird;
Rahmen (Fj), die alle eine gleiche Anzahl von Wörtern aufweisen, wobei jeder Rahmen dazu bestimmt ist, einen von den Rahmendaten unabhängigen Wert (CST), und mindestens ein Auftreten eines Identifikators (i) eines Zählers zu enthalten, wobei jeder geschriebene Rahmen eine Erhöhung oder Verminderung des Wertes des betreffenden Zählers in Bezug auf seinen ersten Wert darstellt;
wobei,
die Headerdaten geschrieben werden, bevor ein erster Frame (Fj) in die Seite (Pl) geschrieben wird;
der aktuelle Wert eines Zählers berechnet wird, indem der erste Wert dieses Zählers gemäß allen Frames (Fj) auf der Seite aktualisiert wird, die den Identifikator (i) dieses Zählers umfassen; und
die Initialisierung einer neuen Seite einhergeht mit dem Schreiben der Headerdaten mit den aktuellen Werten der auf der Grundlage der vorherigen Seite berechneten Zähler als ersten Wert.

2. Das Verfahren nach Anspruch 1, wobei ein neuer Rahmen (Fj) für jede Aktualisierung des Wertes eines Zählers geschrieben wird.

3. Das Verfahren nach Anspruch 1 oder 2, wobei die Rahmen (Fj) nacheinander in eine Seite (Pl) geschrieben werden.

4. Das Verfahren nach einem der Ansprüche 1 bis 3, wobei jeder Rahmen (Fj) ferner dazu bestimmt ist, ein Fehlerkontrollcodewort zu enthalten, das unter Berücksichtigung der anderen Wörter im Rahmen berechnet wird.

5. Das Verfahren nach einem der Ansprüche 1 bis 4, wobei der von den Rahmendaten unabhängige Wert (CST) für alle Rahmen auf der Seite gleich ist.

6. Das Verfahren nach einem der Ansprüche 1 bis 5, wobei jeder Rahmen (Fj) ferner ein Wort zum Speichern des Erhöhungs- oder Verminderungswertes des betreffenden Zählers umfasst.

7. Das Verfahren nach einem der Ansprüche 1 bis 6, wobei der Erhöhungs- oder Verminderungswert die Einheit ist.

8. Eine elektronische Schaltung (1), die Folgendes aufweist:
einen Flash-Speicher (2); und
eine Managementschaltung (11), die konfiguriert ist, um das Verfahren nach einem der Ansprüche 1 bis 7 zu implementieren.

## Claims

1. A method of storing at least one counter (Ci) into a flash memory (2), wherein each page (Pl) of the memory assigned to the storage of the counter(s) comprises:
header data including a first word (MD11) intended to contain a number (1) of the page, one word (Ci) per counter to store a first value thereof, and a second word (MD12) intended to contain an error control code calculated by taking into account first values;
frames (Fj) all having a same number of words, each frame being intended to contain a value (CST) independent from the frame data, and at least one occurrence of an identifier (i) of a counter, each written frame representing an increment or decrement of the value of the concerned counter with respect to its first value;
wherein,
said header data are written before a first frame (Fj) is written into the page (Pl);
the current value of a counter is calculated by updating the first value of this counter according to all the frames (Fj) in the page which comprise the identifier (i) of this counter; and
the initialization of a new page goes along with a writing of the header data with, as a first value, the current values of the counters calculated based on the previous page.

2. The method of claim 1, wherein a new frame (Fj) is written for each update of the value of a counter.

3. The method of claim 1 or 2, wherein the frames (Fj) are written sequentially into a page (PI).

4. The method of any of claims 1 to 3, wherein each frame (Fj) is further intended to contain an error control code word calculated by taking into account the other words in the frame.

5. The method of any of claims 1 to 4, wherein said value (CST) independent from the frame data is the same for all the frames in the page.

6. The method of any of claims 1 to 5, wherein each frame (Fj) further comprises a word for storing the increment or decrement value of the concerned counter.

7. The method of any of claims 1 to 6, wherein the increment or decrement value is the unit.

8. An electronic circuit (1) comprising:
a flash memory (2); and
a management circuit (11) configured to implement the method of any of claims 1 to 7.
